# EUROPÄISCHE PATENTSCHRIFT

(11) **EP 0 829 962 B1**
(45) Veröffentlichungstag und Bekanntmachung des Hinweises auf die Patenterteilung: **26.09.2001**
(21) Anmeldenummer: 97112070.4
(22) Anmeldetag: 14.07.1997
(51) Int. Cl.: H03K 5/08, H04L 25/06

(54) **Schaltung zur Ermittlung und Speicherung eines Signalmittelwertes**
Circuit for determining and storing a signal mean value
Circuit pour déterminer et stocker la valeur moyenne d'un signal

(30) Priorität: 12.09.1996 DE 19637151
(43) Veröffentlichungstag der Anmeldung: 18.03.1998
(73) Patentinhaber: Infineon Technologies AG, 81669 München (DE)
(72) Erfinder: Weber, Stephan, 81739 München (DE)
(74) Vertreter: Zedlitz, Peter, Dipl.-Inf.

(56) Entgegenhaltungen:
- EP-A- 0 133 067
- EP-A- 0 219 037
- DE-A- 4 236 774
- DE-A- 19 612 714
- US-A- 4 686 586
- US-A- 5 274 273

## Beschreibung

Die Erfindung betrifft eine Schaltung zur Ermittlung und Bewertung eines Datensignals, mit einem Signaleingang, an dem ein mit einem Gleichspannungsanteil überlagertes Signal einkoppelbar ist, mit einer Signalbearbeitungseinrichtung, die ein Filter aufweist und einen Teil des Signals weiterleitet, und mit einer Bewertungseinrichtung, die den unveränderten Teil des Signals mit dem von der Signalbearbeitungseinrichtung weitergeleiteten und damit verzögerten Teil des Signals vergleicht und das nicht kontinuierliche Datensignal ermittelt.

Einem Signal sind bedingt durch Offsetspannungen, Toleranzen usw. oft Gleichspannungen überlagert. Um den Arbeitsbereich der Glieder einer Signalkette optimal ausnutzen zu können, ist es notwendig, diese Gleichspannungen z.B. durch Ermittlung des Gleichspannungsanteils und anschließende Subtraktion zu kompensieren. Gleichspannungsanteile, die auch als Gleichgrößen bezeichnet werden, werden üblicherweise durch Tiefpaßfilterung ermittelt. Ein Beispiel für die Notwendigkeit einer solchen Schaltung ist die Synchronisation in einem TDMA-System (Time Division Multiple Access). Unter einem solchen System versteht man einen Vielfachzugriff im Zeitmultiplexverfahren. Dabei überträgt ein Sender in einer sogenannten Präambel ein Wechselsignal, welches einen Gleichspannungsanteil von Null aufweist. Durch die nichtidealen Eigenschaften in der Sendekette treten am Empfängerausgang zusätzliche Gleichspannungsanteile auf, die kompensiert werden müssen, um eine optimale Übertragungsqualität zu erhalten. Da in einer normalen Datenübertragung auch Gleichspannungsanteile oder besonders niederfrequente Anteile denkbar sind, muß der Gleichspannungsanteil innerhalb der Präambel, die keinen Gleich spannungsanteil aufweist, ermittelt und dann gespeichert werden.

Ein Beispiel für ein solches TDMA-System, in dem sich diese Probleme stellen, ist der neue europäische Schnurlos-Telefonstandard DECT (Digital European Cordless Telephone).

Bei einer bekannten Schaltung wird der Gleichspannungsanteil durch Tiefpaßfilterung ermittelt. Dabei wird hinsichtlich der Filtergrenzfrequenz und der dazu umgekehrt proportionalen Zeitkonstante ein Kompromiß zwischen Geschwindigkeit und Genauigkeit geschlossen. Problematisch ist dabei insbesondere der Schaltpunkt, bei dem von Filterung auf Speicherung umgeschaltet wird, da das System nicht synchronisiert ist. Man kann entweder auf Kosten der Genauigkeit möglichst früh auf Speicherung schalten oder den Übergang von Präambel zu den normalen Daten abwarten. Auch letzteres kann bei Verwendung konventioneller linearer Filter nur mit begrenzter Genauigkeit erfolgen, da die Umschaltung erst mit einer deutlichen Verspätung erkannt werden kann. In diesem Fall erfolgt die Mittelwertbildung auch über einen Teil der Daten, deren Mittelwert aber nicht 0 sein muß. Je später die Erkennung des Endes der Präambel und das Umschalten auf Speicherung erfolgt, desto fehlerhafter wird die Mittelwertermittlung. In einem bekannten Lösungsansatz wird die Verzögerung durch Mittelwertbildung nicht des aktuellen Signals sondern eines verzögerten Signals gelöst. Hierfür werden einfache RC-Glieder verwendet. Die Sprungantwort solcher Filter hat immer einen monotonen Charakter, d.h., daß das Signal nach Ende der Präambel systematisch in eine Richtung wegläuft und so einen unter Umständen erheblichen Haltefehler verursacht. Dieser Fehler wird bei Filtern hoher Ordnung kleiner, verschwindet aber nicht völlig.

Eine deratige gattungsgemäße Schaltung zur Ermittlung und Speicherung eines Signalmittelwertes ist beispielsweise in der US 5,274,273 beschrieben. Dort wird ein Signal lediglich über eine einfache Verzögerungseinrichtung mit dem nicht verzögerten Anteil des Signals verglichen.

Der Erfindung liegt die **Aufgabe** zugrunde, eine Schaltung der eingangs genannten Art zu schaffen, mit der ein Signalmittelwert auf besonders präzise und zuverlässige Weise ermittelt und gespeichert werden kann.

Erfindungsgemäß wird diese Aufgabe durch eine gattungsgemäße Schaltungsanordnung mit den Merkmalen des Patentanspruchs 1 gelöst.

Demgemäß ist eine Schaltung der eingangs genannten Art vorgesehen, bei der die Signalbearbeitungseinrichtung ferner einen Allpaß und eine Track&Hold-Schaltung aufweist, und bei der das Filter und der Allpaß derart aufeinander abgestimmt sind, daß eine Sprungantwort zu einem Zeitpunkt Null ist, an dem der Anfang des Signals erkannt werden kann und an dem das Ausgangssignal vom Filter abgetastet werden soll.

Anders ausgedrückt bedeutet dies, daß durch Hinzunahme eines Allpaßes die Sprungantwort so optimiert werden kann, daß bei bekanntem Abschaltpunkt der Haltefehler Null wird.

Der Allpaß überträgt alle Frequenzen und bewirkt eine Phasenverschiebung. Das Filter und die übrigen Elemente der Signalbearbeitungseinrichtung sind sogenannte Minimal-Phasensysteme, bei denen Amplitudengang und Phasengang fest gekoppelt sind. Durch die Reihenschaltung des Allpaßes und des Minimal-Phasensystems ergibt sich ein stabiles System im Sinne der Systemtheorie.

Prinzipiell ist es möglich, die Schaltung so aufzubauen, daß das Filter der Signalbearbeitungseinrichtung ein Hochpaß ist. Bevorzugt ist jedoch die Verwendung eines Tiefpaßes in der Sig-nalbearbeitungseinrichtung, so daß in der Bewertungseinrichtung das von der Signalbearbeitungseinrichtung ermittelte Signal von dem Eingangssignal abgezogen werden kann. Die Signalbearbeitungseinrichtung weist weiterhin bevorzugt eine Track&Hold-Schaltung (Folgen und Halten) auf, in der der ermittelte Gleichspannungsanteil gespeichert werden kann. Die Track&Hold-Schaltung ist grundsätzlich vergleichbar mit einer Sample- und Holdschaltung. In der Track&Hold-Schaltung kann der ermittelte Gleichspannungsanteil gespeichert. Der Allpaß ist innerhalb der Signalbearbeitungseinrichtung in Reihe zu den anderen Elementen geschaltet.

Weiterhin ist am Signaleingang bevorzugt ein Pufferverstärker vorgesehen, mit dem die ankommenden Signale verstärkt werden können. Die Bewertungseinrichtung weist bevorzugt einen Komparator auf, mit dem sich die Signalkompensation besonders leicht durchführen läßt.

In einer bevorzugten Ausführungsform der Erfindung sind der Allpaß und der Tiefpaß symmetrisch aufgebaut, da dann die notwendige Phasenumkehr bereits automatisch erfolgt und keine weiteren Offsetspannungen durch zusätzliche Inverter erzeugt werden. Der Allpaß und der Tiefpaß können besonders einfach im wesentlichen von Kondensatoren und Widerständen gebildet werden. Dabei weist der Allpaß parallel zueinander geschaltete Widerstände und zwei Kondensatoren auf, die kreuzweise mit den Widerständen verbunden sind.

In einer Weiterbildung der Erfindung sind insbesondere Allpaß und Tiefpaß oder sogar die gesamte Schaltung auf einem Chip integriert, da dann keine zusätzlichen Anschlüsse oder externe Bauelemente benötigt werden. Weiterhin wird bevorzugt eine Abgleicheinrichtung vorgesehen, da die großen Toleranzen integrierter Bauelemente oft einen Abgleich erforderlich machen, der entweder bei der Chipherstellung oder beim Abgleich des gesamten Systems durchgeführt werden kann.

Nachfolgend wird die Erfindung anhand eines in der Zeichnung dargestellten Ausführungsbeispiels weiter erläutert. Im einzelnen zeigen die schematischen Darstellungen in
- Fig. 1: ein Prinzipschaltbild einer erfindungsgemäßen Schaltung;
- Fig. 2: ein Ausführungsbeispiel eines erfindungsgemä ßen Allpaß-Tiefpaß-Blocks, und
- Fig. 3: ein Diagramm einer Sprungantwort einer erfindungsgemäßen Schaltung im Vergleich zu einer konventionellen Schaltung.

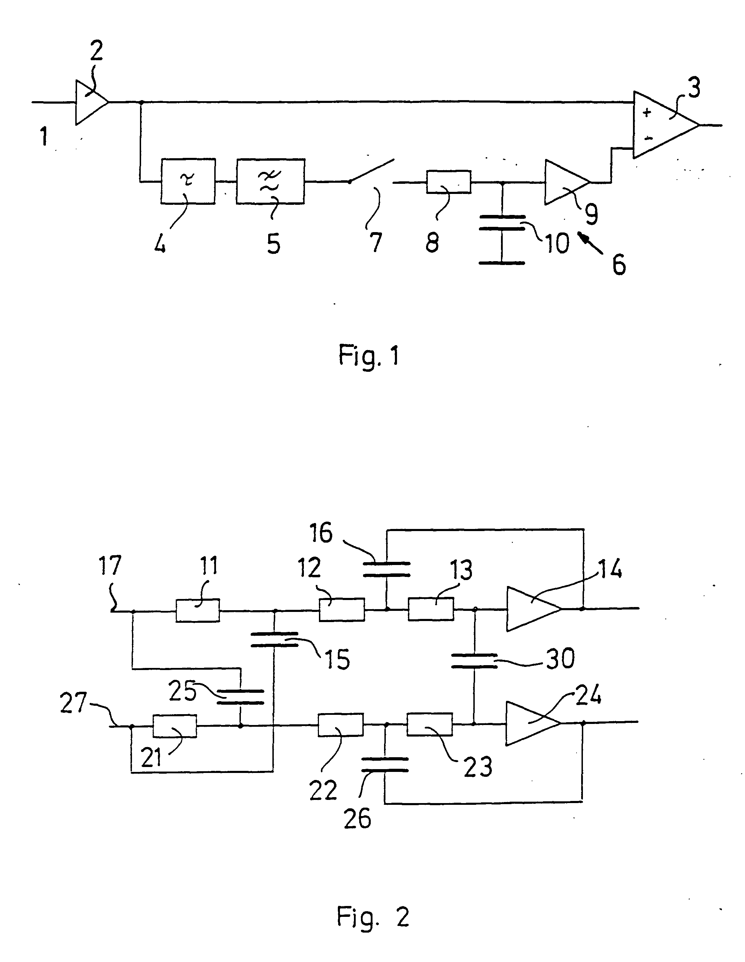

In Fig. 1 ist ein Blockschaltbild einer erfindungsgemäßen Schaltung dargestellt. Am Signaleingang 1 ist ein Pufferverstärker 2 angeordnet, der direkt mit dem positiven Eingang eines Komparators 3 verbunden ist. Hinter dem Pufferverstärker 2 zweigt eine parallele elektrische Verbindung zum negativen Eingang des Komparators 3 ab. In dieser Verbindung ist die Signalbearbeitungseinrichtung angeordnet, die einen Allpaß 4, einen Tiefpaßfilter 5 und eine Track&Hold-Schaltung 6 aufweist, die in Reihe geschaltet sind. Die Track&Hold-Schaltung 6 weist ein Schaltelement 7, einen dazu in Reihe geschalteten Widerstand 8 und einen Verstärker 9 auf. Zwischen dem Widerstand 8 und dem Verstärker 9 liegt ein gegen Masse geschalteter Kondensator 10.

In Fig. 2 ist ein Ausführungsbeispiel eines erfindungsgemäßen Allpaß-Tiefpaß-Blocks dargestellt. Dieser ist in einer symmetrischen Schaltung ausgeführt, die sich im wesentlichen auf die beiden parallelen elektrischen Verbindungen 17 und 27 zurückführen läßt. In der elektrischen Verbindung 17 sind in Reihe die Widerstände 11, 12 und 13 und ein Verstärker 14 angeordnet. Hinter dem Verstärker 14 erfolgt eine Rückkopplung über einen Kondensator 16, der mit der elektrischen Verbindung 17 zwischen den Widerständen 12 und 13 verbunden ist. Die elektrische Verbindung 27 ist analog mit dem Widerständen 21, 22 und 23 und einem Verstärker 24 und einem Kondensator 26 aufgebaut. Zwischen den Widerständen 11 und 12 ist eine elektrische Verbindung über einen Kondensator 15 zu der elektrischen Verbindung 27 vorgesehen, die vor dem Widerstand 21 angeschlossen ist. Spiegelbildlich dazu ist sozusagen kreuzweise der Kondensator 25 vorgesehen. Weiterhin ist ein Kondensator 30 zur Verbindung der elektrischen Verbindungen 17 und 27 vor den Verstärkern 14 und 24 vorgesehen. Die Widerstände 11, 12, 21 und 22 und die Kondensatoren 15 und 25 bilden den Allpaß, während die übrigen Elemente den Tiefpaß realisieren.

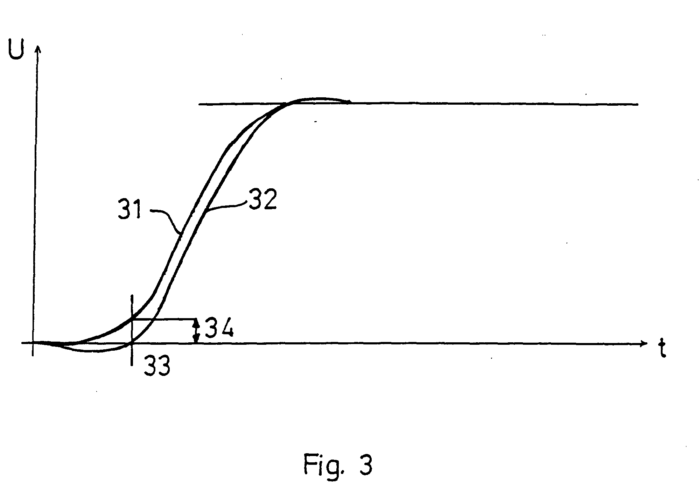

In Fig. 3 ist die Sprungantwort einer erfindungsgemäßen Schaltung im Vergleich mit einer konventionellen Schaltung grafisch dargestellt. Dabei ist auf der X-Achse die Zeit und auf der Y-Achse die Spannung aufgetragen. Für die Mittelwertbildung ist eine prinzipbedingte Verzögerung notwendig. Diese kann beispielsweise 2 Bit betragen und ist in der Figur auf der X-Achse an der mit 33 bezeichneten Stelle angenommen. Da die Sprungantwort einer konventionellen Schaltung, deren Verlauf mit 31 bezeichnet ist, einen monotonen Charakter hat, ergibt sich ein prinzipbedingter Fehler, da nach der notwendigen Verzögerung die Kurve 31 von Null verschieden ist. Die Größe dieses Fehlers ist mit 34 dargestellt.

Demgegenüber kann durch die Verwendung eines Allpaßes in der erfindungsgemäßen Schaltung eine gänzlich andere Sprungantwort erreicht werden, die in der Zeichnung mit 32 bezeichnet ist. Die Sprungantwort der erfindungsgemäßen Schaltung nimmt in der Anfangsphase negative Spannungswerte an und verläuft dann nach kurzer Zeit durch einen Nullpunkt. Das System wird nun so abgestimmt, daß gerade beim Durchlauf der Sprungfunktion durch den Nullpunkt geschaltet wird und der zu diesem Zeitpunkt ermittelte Gleichspannungsanteil des Signals in der Track&Hold-Schal-tung gespeichert und vom eigentlichen Signal subtrahiert wird.

## Patentansprüche

1. Schaltung zur Ermittlung und Bewertung eines Datensignals,
(a) mit einem Signaleingang (1), an dem ein mit einem Gleichspannungsanteil überlagertes Signal einkoppelbar ist,
(b) mit einer Signalbearbeitungseinrichtung (4, 5, 6), die ein Filter (5) aufweist und einen Teil des Signals weiterleitet,
(c) mit einer Bewertungseinrichtung (3), die den unveränderten Teil des Signals mit dem von der Signalbearbeitungseinrichtung (4, 5, 6) weitergeleiteten und damit verzögerten Teil des Signals vergleicht und das nicht kontinuierliche Datensignal ermittelt,
**dadurch gekennzeichnet,**
(d) daß die Signalbearbeitungseinrichtung (4, 5, 6) ferner einen Allpaß (4) und eine Track&Hold-Schaltung (6) aufweist, und
(e) daß das Filter (5) und der Allpaß (4) derart aufeinander abgestimmt sind, daß eine Sprungantwort zu einem Zeitpunkt Null ist, an dem der Anfang des Signals erkannt werden kann und an dem das Ausgangssignal vom Filter (5) abgetastet werden soll.

2. Schaltung nach Anspruch 1,
**dadurch gekennzeichnet,**
**daß** die Signalbearbeitungseinrichtung (4, 5, 6) einen Tiefpaß (5) aufweist.

3. Schaltung nach Anspruch 2,
**dadurch gekennzeichnet,**
**daß** der Tiefpaß (5) und die Track&Hold-Schaltung (6) als Minimal-Phasensysteme ausgelegt sind.

4. Schaltung nach einem der vorhergehenden Ansprüche,
**dadurch gekennzeichnet,**
**daß** am Signaleingang (1) ein Pufferverstärker (2) vorgesehen ist.

5. Schaltung nach einem der vorhergehenden Ansprüche,
**dadurch gekennzeichnet,**
**daß** die Bewertungseinrichtung (3) einen Komparator (3) aufweist.

6. Schaltung nach einem der Ansprüche 2 bis 5,
**dadurch gekennzeichnet,**
**daß** der Allpaß (4) und der Tiefpaß (5) zueinander symmetrisch aufgebaut sind.

7. Schaltung nach einem der vorhergehenden Ansprüche 2 bis 6, **dadurch gekennzeichnet,**
**daß** der Allpaß (4) und der Tiefpaß (5) im wesentlichen aus Kondensatoren und Widerständen aufgebaut sind.

8. Schaltung nach einem der vorhergehenden Ansprüche,
**dadurch gekennzeichnet,**
**daß** der Allpaß (4) parallel zueinander geschaltete Widerstände (11, 12, 21, 22) und zwei Kondensatoren (15, 25) aufweist, die kreuzweise mit den Widerständen (11, 12, 21, 22) verbunden sind.

9. Schaltung nach einem der vorhergehenden Ansprüche,
**dadurch gekennzeichnet,**
**daß** die Schaltung und insbesondere der Allpaß (4) und der Tiefpaß (5) auf einem einzigen elektronischen Baustein integriert sind.

10. Schaltung nach einem der vorhergehenden Ansprüche,
**dadurch gekennzeichnet,**
**daß** eine Abgleicheinrichtung vorgesehen ist.

## Claims

1. Circuit for determining and evaluating a data signal,
(a) with a signal input (1), at which a signal superimposed by a d.c. component can be coupled in,
(b) with a signal processing device (4, 5, 6), which has a filter (5) and which passes on part of the signal,
(c) with an evaluation device (3) which passes on the unchanged part of the signal with that from the signal processing device (4, 5, 6) and compares the thus delayed part of the signal and determines the non-continuous data signal, **characterised in that**,
(d) signal processing device (4, 5, 6) also has an all-pass filter (4) and a track and hold circuit (6), and
(e) the filter (5) and the all-pass filter (4) are tuned to each other in such a way that a step response is zero at a time point at which the start of the signal can be detected and at which the output signal is to be sampled by the filter (5).

2. Circuit in accordance with Claim 1, **characterised in that** the signal processing device (4, 5, 6) has a low-pass filter (5).

3. Circuit in accordance with Claim 2, **characterised in that** the low-pass filter (5) and the track and hold circuit (6) are designed as minimum phase systems.

4. Circuit in accordance with one of the preceding claims, **characterised in that** a buffer amplifier (2) is provided at the signal input (1).

5. Circuit in accordance with one of the preceding claims, **characterised in that** the evaluation device (3) has a comparator (3).

6. Circuit in accordance with one of Claims 2 to 5, **characterised in that** the all-pass filter (4) and low-pass filter (5) are constructed symmetrically relative to each other.

7. Circuit in accordance with one of the preceding claims 2 to 6, **characterised in that** the all-pass filter (4) and the low-pass filter (5) are essentially constructed from capacitors and resistors.

8. Circuit in accordance with one of the preceding claims, **characterised in that** the all-pass filter (4) has resistors (11, 12, 21, 22) and two capacitors (15, 25) arranged parallel to each other in the circuit, which are crosswise connected to resistors (11, 12, 21, 22).

9. Circuit in accordance with one of the preceding claims, **characterised in that** the circuit, and particularly the all-pass filter (4) and low-pass filter (5), are integrated on a single electronic chip.

10. Circuit in accordance with one of the preceding claims, **characterised in that** a balancing device is provided.

## Revendications

1. Circuit pour déterminer et évaluer un signal de données,
(a) avec une entrée de signal (1) à laquelle un signal auquel est superposée une partie continue de la tension peut être accouplé,
(b) avec un dispositif (4, 5, 6) de traitement du signal qui présente un filtre (5) et qui laisse passer une partie du signal,
(c) avec un dispositif d'évaluation (3) qui compare la partie inchangée du signal à la partie du signal que le dispositif (4, 5, 6) de traitement du signal a laissé passer et qui a donc été retardée, et qui détermine le signal de données non continu,
**caractérisé en ce que**
(d) le dispositif (4, 5, 6) de traitement du signal présente en outre un passe-tout (4) et un circuit (6) de suivi et de maintien, et
(e) en ce que le filtre (5) et le passe-tout (4) sont accordés l'un à l'autre de telle sorte qu'une réponse impulsionnelle soit nulle en un instant auquel le début du signal peut être reconnu et auquel le signal de sortie doit être évalué par le filtre (5).

2. Circuit selon la revendication 1, **caractérisé en ce que** le dispositif (4, 5, 6) de traitement du signal présente un passe-bas (5).

3. Circuit selon la revendication 2, **caractérisé en ce que** le passe-bas (5) et le circuit (6) de suivi et de maintien sont conçus comme systèmes à déphasage minimal.

4. Circuit selon l'une des revendications précédentes, **caractérisé en ce qu'**un amplificateur tampon (2) est prévu à l'entrée de signal (1).

5. Circuit selon l'une des revendications précédentes, **caractérisé en ce que** le dispositif d'évaluation (3) présente un comparateur (3).

6. Circuit selon l'une des revendications 2 à 5, **caractérisé en ce que** le passe-tout (4) et le passe-bas (5) sont conçus symétriquement l'un par rapport à l'autre.

7. Circuit selon l'une des revendications précédentes 2 à 6, **caractérisé en ce que** le passe-tout (4) et le passe-bas (5) sont essentiellement constitués de condensateurs et de résistances.

8. Circuit selon l'une des revendications précédentes, **caractérisé en ce que** le passe-tout (4) présente des résistances (11, 12, 21, 22) branchées en parallèle et deux condensateurs (15, 25) qui sont reliés en croix aux résistances (11, 12, 21, 22).

9. Circuit selon l'une des revendications précédentes, **caractérisé en ce que** le circuit, et en particulier le passe-tout (4) et le passe-bas (5), sont intégrés en un seul module électronique.

10. Circuit selon l'une des revendications précédentes, **caractérisé en ce qu'**un dispositif d'équilibrage est prévu.
